# EUROPEAN PATENT APPLICATION

(11) **EP 2 657 372 A1**
(43) Date of publication of application: **30.10.2013**
(21) Application number: 13162454.6
(22) Date of filing: 05.04.2013
(51) Int. Cl.: C30B 11/00, C30B 15/10, C30B 29/20, C30B 35/00

(54) **Non-monolithic crucible**

(30) Priority: 28.04.2012 CN 201210131320
(71) Applicant: Luoyang Hi-Tech Metals Co., Ltd., 471003 Luoyang (CN)
(72) Inventor: Uhlenhut, Henning, 471003 Luoyang (CN)
(74) Representative: Pallini, Diego

(57) **Abstract**

The present invention provides a non-monolithic crucible for sapphire production and methods of making and using the same.

## Description

### FIELD OF THE INVENTION

The present invention generally relates to the art of sapphire production.

### BACKGROUND OF THE INVENTION

Synthetic sapphire has been produced since many years by several different processes. Generally the sapphire crystal grows through directional solidification of liquid Al₂O₃. The liquid Al₂O₃ needs to be contained in a crucible at temperatures above 2025 °C. For that purpose Molybdenum and Tungsten did prove to be suitable crucible materials. Over the past years technology has been developed to grow sapphire with increasing diameter. While 200 mm diameter and 300 mm diameter have been standard diameters in the past, now manufactures are looking to grow crystals with a diameter of 380 mm. The trend to increase diameter in combination with the increasing height of the crucible is a challenge for the manufacturing of the crucibles. Meanwhile a significant amount of crucibles with a diameter of 380 mm and a height of 430 mm is needed. A typical wall thickness is 4 to 8 mm. Most likely even larger crucibles are needed for the manufacturing of sapphire in the future.

Currently manufacturers of the production equipment for sapphire as well as the users of this equipment are using monolithic crucibles, i.e. the crucibles used for this process are comprised of one part only. These crucibles can be used once only -- when the production of sapphire is complete, one will need to break the crucibles to take out the sapphire product. Consequently, according to the current practice, the whole body of the crucibles, which are formed of expensive materials such as molybdenum and tungsten, has to be broken upon completion of sapphire production and remade for next use, resulting in substantial capital and labor waste.

Therefore, there is a need for more economic and efficient use of crucibles in sapphire production.

The embodiments described below address the above identified issues and needs.

### SUMMARY OF THE INVENTION

In one aspect of the present invention, it is provided a non-monolithic crucible, which comprises a bottom part, at least one top part, and one or more optional additional top part,
wherein the bottom part that comprises a monolithic bottom crucible is capable of securely containing a liquid of Al₂O₃;
wherein the at least one top part and one or more optional additional top part are mounted onto of the bottom part and on top of each other forming a joint(s) between the parts so as to be able to securely contain a powder of Al₂O₃ without significant powder leakage through any of the parts or through any of the joints between the parts.

In some embodiments of the invention non-monolithic crucible, in combination with any of the above embodiments, the non-monolithic crucible is made by:
a) CIP - machine on lathe - sinter - machine on lathe,
b) CIP - sinter - machine on lathe,
c) CIP - sinter,
d) HIP - machine on lathe,
e) HIP,
f) assembling the crucible from several parts by joining (welding) - machine on lathe,
g) assembling the crucible from several parts by joining (welding),
h) deep drawing - machine on lathe,
i) deep drawing,
j) spin forming - machine on lathe,
k) spin forming, or
l) a modification of any of the above a)-k) operations.

In some embodiments of the invention non-monolithic crucible, in combination with any of the above embodiments, the non-monolithic crucible is made from molybdenum and/or tungsten.

In some embodiments of the invention non-monolithic crucible, in combination with any of the above embodiments, the top part is a recycled top part.

In some embodiments of the invention non-monolithic crucible, in combination with any of the above embodiments, the joint comprises an anti-sticking material to prevent the joining of top and bottom crucibles by sintering during the use of the non-monolithic crucible.

In some embodiments of the invention non-monolithic crucible, in combination with any of the above embodiments, the anti-sticking material comprises zirconia or tungsten, and wherein the non-monolithic crucible is made from molybdenum.

In some embodiments of the invention non-monolithic crucible, in combination with any of the above embodiments, the anti-sticking material comprises coarse powder particles which do not undergo adverse chemical reactions and have low sinter activity at a high temperature.

In some embodiments of the invention non-monolithic crucible, in combination with any of the above embodiments, the contact area between bottom part and the top part(s) is minimized.

In some embodiments of the invention non-monolithic crucible, in combination with any of the above embodiments, the joint further comprises a position lever to break loose the contact area.

In another aspect of the present invention, it is provided a method of fabricating a non-monolithic crucible comprising a bottom part, at least one top part, and one or more optional additional top part, which method comprising:
providing at least one top part and one or more optional additional top part;
providing one bottom part; and
forming the non-monolithic crucible.

In some embodiments of the method, in combination with any of the above embodiments, the non-monolithic crucible is as any of the above described embodiments.

In another aspect of the present invention, it is provided a method of using a non-monolithic crucible comprising a bottom part, at least one top part, and one or more optional additional top part, which method comprising:
providing a powder of Al₂O₃ to a non-monolithic crucible,
heating the Al₂O₃ at a temperature to generate a liquid of Al₂O₃,
controlling the temperature of the liquid of Al₂O₃ so as to allow a seed of sapphire to grow at a controlled rate into a sapphire product of desired dimension, removing the top part from the bottom part, and removing the sapphire product from the bottom part to obtain the sapphire product.

In some embodiments of the method, in combination with any of the above embodiments, the non-monolithic crucible is as any of the above described embodiments.

### BRIEF DESCRIPTION OF THE DRAWINGS

Figure 1 shows a schematic of non-monolithic crucible comprised of a bottom crucible and only one top part.
Figures 2A-2D show a few examples of the design of the top rim to hold the top part of the invention non-monolithic crucible.
Figures 3A-3D show a few examples of the invention non-monolithic crucibles.
Figure 4 shows the contact area of a joint of an embodiment design between the top part and the bottom part of invention non-monolithic crucible.

### DETAILED DESCRIPTION OF THE INVENTION

### Definitions

Wherever applicable, the term "safely" shall mean the condition of containing a liquid of Al₂O₃ and a sapphire product of high temperature being secure and safe, which is within the knowledge of one of ordinary skill in the art. In some embodiments, the term "safe" is used interchangeably with the term "secure".

Wherever applicable, the term "without significant powder leakage" shall mean a powder leakage of less than about 10%. In some embodiments, the powder leakage is less than about 5%, less than about 2%, or less than about 1%.

Wherever application, the term "anti-sticking material" shall mean a material capable of preventing the joining of top and bottom crucibles by sintering during the use of the non-monolithic crucible.

Wherever application, the term "seed sapphire" shall mean a seed formed in-situ or provided to a sapphire manufacturing crucible, which is within the knowledge of one of ordinary skill in the art. In some embodiments, wherever desirable, the seed can be a crystal formed from a material other than Al2O3.

### Non-monolithic crucibles

In one aspect of the invention, it is provided a crucible for use in the growth of synthetic sapphire or a similar process. The invention comprises a crucible, which comprises at least two or more parts, i.e. one bottom crucible (2), one or more top parts (1), and auxiliary parts as needed. The bottom crucible (2) comprises a monolithic crucible (bottom crucible) suitable to contain a liquid Al₂O₃ used to make sapphire, and the rim of the bottom crucible comprises a design suitable to hold the top part. The top part (1) is placed onto the rim of the bottom crucible (2) to extend the height of the bottom crucible. Alternatively more than one top part (1) can be placed onto the bottom crucible (2), one over another other.

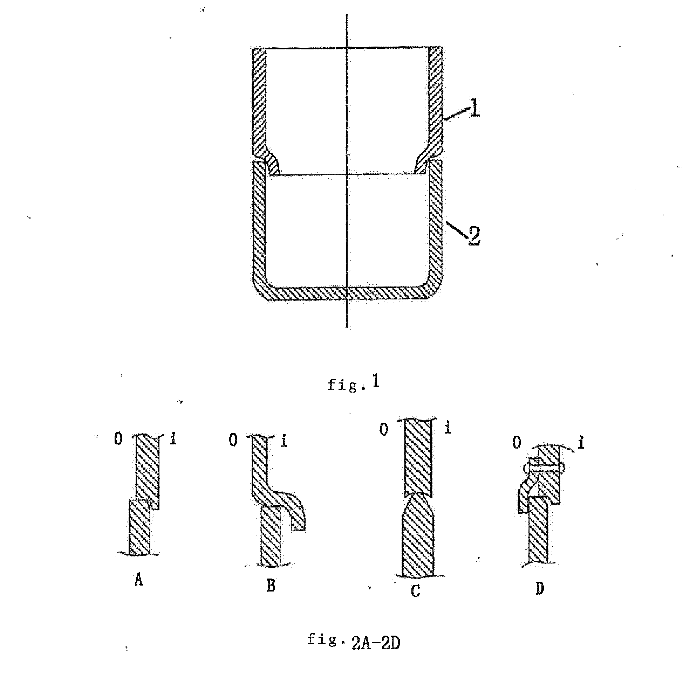

The assembly of bottom (2) and top part (1) is suitable to contain the Al₂O₃ powder, which is the starting material for the process of making sapphire. The function of the top part (1) is to hold the Al₂O₃ powder, which is filled to a level higher than the height of the bottom crucible (2) at the beginning of the process. As the powder melts, the level of the filling falls below the top rim of the bottom crucible and the top part has no further function. The joint (3) between top (1) and bottom crucible (2) or between two top parts is designed to prevent the Al₂O₃ powder from leaking, but does not need to prevent the liquid Al₂O₃ from leaking since the Al₂O₃ powder is provided in an amount such that the liquid generated therefrom will fill the bottom crucible (2) below the joint (3). The top part (1) can be reused after the sapphire has been grown from the liquid Al₂O₃. Figure 1 shows a schematic of non-monolithic crucible comprised of a bottom crucible (2) and only one top part (1).

In some embodiments, one can fabricate molybdenum and/or tungsten crucibles of the required size by joining a bottom plate with a tube segment, where the tube segment can be a seamless tub, a welded tube or made otherwise from sheet. It is also possible to weld a tube segment onto a crucible of small height, thus extending it to the required height. A caveat is, when molybdenum or tungsten is used to form the bottom crucible, the weld could be weak as compared to the rest of the structure due to its brittleness.

In some embodiments, one can fabricate molybdenum and/or tungsten crucibles of the required size by cold isostatic pressing (CIP) powder to make the required shape and subsequent sintering. In these embodiments, for large size crucibles, the contour accuracy can be maintained by preparing excessive wall thicknesses in the initial stage of the manufacturing process and removing the excess material later by machining the exactly required contour on a lathe.

In some embodiments, one can fabricate molybdenum and/or tungsten crucibles of the required size by hot isostatic pressing (HIP). Generally it will be necessary to finish the fabrication by machining the HIPed crucible on a lathe.

In some embodiments, one can fabricate molybdenum crucibles of the required size by deep drawing or by spin forming. For both manufacturing techniques, molybdenum sheet is used as a starting material. While deep drawing is efficient only for large numbers of parts, spin forming is efficient for medium to small numbers of parts. Both processes are generally limited to making crucibles with a height to diameter ratio of 2. Further they are limited by the availability of Molybdenum sheet having the required width to make large crucibles. When deep drawing is employed it is necessary to use a hydrogen atmosphere furnace, which allows one to place the sheet to be deep drawn into its hot zone. For the currently required crucible sizes (380 mm x 430 mm) the furnace needs a useful hot zone of at least one by one meter. For larger crucible sizes an even larger furnace will be required.

The non-monolithic crucible for the manufacturing of sapphire comprises a bottom crucible, which resembles a monolithic crucible with the difference being that the rim of the bottom crucible is designed to hold one or more top parts safely and securely. The bottom crucible of the non-monolithic crucible can be made by all of the methods described as state of the art. A few examples of the design of the top rim to hold the top part of the invention non-monolithic crucible are shown in Figures 2A-2D. In Figure 2, "o" denotes outside, and "i" denotes inside.

In some embodiments, the top part(s) of the non-monolithic crucible is a tube segment, which is designed to be placed safely onto the bottom crucible. The tube segment can be manufactured in various different ways described below:

In some embodiments, one can fabricate the top part of the non-monolithic crucible by making a welded tube of the required size. The weld can be continuous or non-continuous, for example

In some embodiments, one can fabricate the top part of the non-monolithic crucible by making a riveted tube of the required size.

In some embodiments, one can fabricate the top part of the non-monolithic crucible by making a CIP/sinter or HIP tube of the required size.

In some embodiments, one can fabricate the top part of the non-monolithic crucible by making a seamless tube by deep drawing, spin forming, etc.

In some embodiments, one can fabricate the top part of the non-monolithic crucible by any other method as long as the resultant top part will prevent the powder from leaking out and can be safely placed on top of the bottom crucible.

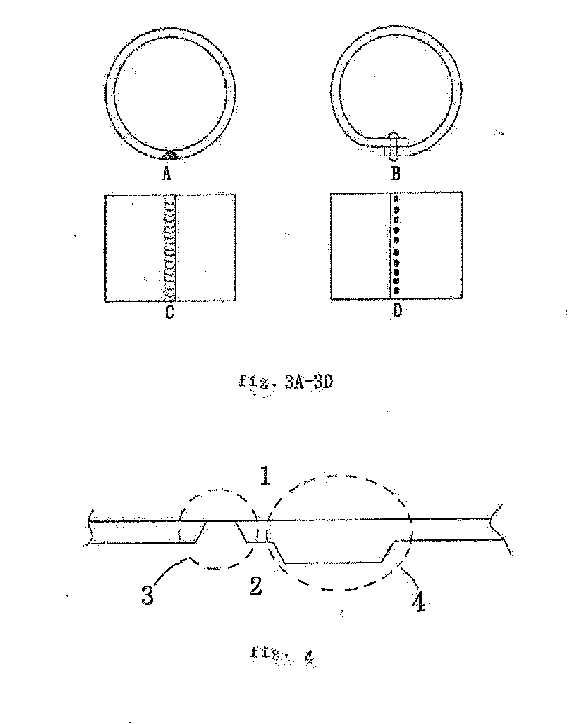

Some examples of the invention crucibles are shown in Figure 3, which illustrate, and shall not be construed to limit, the scope of the invention. Other designs are conceivable. The underlying idea of the invention is to have one or more top parts, which can be reused. Another underlying idea of the invention is to be able to use smaller and thus cheaper manufacturing equipment. Another underlying idea of the invention is to be able to produce a useful non-monolithic crucible using materials, which are cheaper than those necessary to produce monolithic crucibles of the same size.

Due to the high temperatures during the sapphire manufacturing process it is necessary to prevent the top and bottom crucible from sintering together, if the top part is to be re-used. This can be achieved by several methods.

The contact area between top (1) and bottom crucible (2) can be minimized through appropriate design of the joint (3). Thus sintering will occur only in the narrow contact areas. In order to be able to reuse the top part (1) after it has been sintered to the bottom crucible (2) the narrow contact areas can be broken without affecting the integrity of the top part (Figure 4). The joint (3) between bottom and top part can be designed, so that coarse powder particles can be placed in the joint (3) without falling into the crucible. Particles with no adverse chemical reactions and with low sinter activity at high temperatures can be chosen. Suitable particles include, but are not limited to zirconia and tungsten. Due to the low sintering activity the top part (1) can be removed without damage from the bottom crucible (2) by breaking the loose connection between the top part and the bottom crucible at the joint (3). Provisions can be made at the joint (3), which help to break the slightly sintered joint without breaking the top part (1) (Figure 4).

### Method of fabrication

In another aspect of the present invention, it is provided a method of fabricating a non-monolithic crucible comprising a bottom part, at least one top part, and one or more optional additional top part, which method comprising:
providing at least one top part and one or more optional additional top part;
providing one bottom part; and
forming the non-monolithic crucible.

In some embodiments of the method, in combination with any of the above embodiments, the non-monolithic crucible is as any of the above described embodiments.

In some embodiments, the method of fabricating a non-monolithic crucible involves at least one of the following operations:
a) CIP - machine on lathe - sinter - machine on lathe,
b) CIP - sinter - machine on lathe,
c) CIP - sinter,
d) HIP - machine on lathe,
e) HIP,
f) assembling the crucible from several parts by joining (welding) - machine on lathe,
g) assembling the crucible from several parts by joining (welding),
h) deep drawing - machine on lathe,
i) deep drawing,
j) spin forming - machine on lathe,
k) spin forming, or
l) a modification of any of the above a)-k) operations.

The above (a)-(l) operations are either described previously or within the knowledge of a person of ordinary skill in the art of metallic fabrication.

### Use of the invention

In another aspect of the present invention, it is provided a method of using a non-monolithic crucible comprising a bottom part, at least one top part, and one or more optional additional top part, which method comprising:
providing a powder of Al₂O₃ to a non-monolithic crucible,
heating the Al₂O₃ at a temperature to generate a liquid of Al₂O₃,
controlling the temperature of the liquid of Al₂O₃ so as to allow a seed of sapphire to grow at a controlled rate into a sapphire product of desired dimension, removing the top part from the bottom part, and
removing the sapphire product from the bottom part to obtain the sapphire product.

In some embodiments of the method, in combination with any of the above embodiments, the non-monolithic crucible is as any of the above described embodiments.

The following describes the use of the invention in general terms. Details may vary depending on specific designs of the sapphire manufacturing equipment.

Al₂O₃ powder is filled into the Molybdenum crucible. The crucible with the powder is placed in a furnace and heated to melt the powder. As the powder melts the filling level decreases significantly, because the settled apparent density of the powder is significantly lower than the density of the liquid. The liquid then is directionally solidified by imposing a temperature gradient on the liquid. The process is controlled in a way, that a seed crystal will grow and determine the crystal orientation of the finished sapphire. Once all liquid Al₂O₃ has solidified the maximum size of the sapphire has been reached and the process ends.

The decreasing filling level during the melting of the powder allows the use of the invention. While it is necessary for the crucible to be able to contain a high filling level of powder without any leaking of the powder, it is necessary to be able to contain a lower filling level of liquid without any leakage. This circumstance allows for the use of the proposed invention. The non-monolithic crucible consists of a bottom crucible, which is very similar to a standard monolithic crucible. Only the design of the bottom crucible allows one to safely place a top part onto the rim of the bottom crucible, which increases the total height of the crucible. The joint between bottom and top part has to be designed in a way that the power, which is filled beyond the height of the joint, will not leak. The joint between bottom and top part has to be designed in a way that the top and bottom crucible can be separated easily after the sapphire has been produced. The height of the bottom crucible has to be such that the maximum level of the liquid will be below the joint. The joint between the bottom and the top part can be designed in a way that it is compatible with the manufacturing equipment. If the design of the non-monolithic crucible fulfills these conditions, then the non-monolithic crucible can be used in the same way as the standard monolithic crucible with the advantages as described below.

### Advantages of the invention

The invention allows a cost efficient way to produce crucibles as needed for the growth of sapphire. The invention can be applied to all of the above mentioned manufacturing methods for crucibles.

When making crucibles by CIP/sinter or by HIP technology, then the smaller size of the individual parts of the non-monolithic crucible as compared to the size of the monolithic crucible allows the use of smaller, i.e. cheaper, equipment and it allows a better shape control during the manufacturing process. Shape control is a problem, because the shrinkage of powder during sintering is non-uniform, resulting in distortion of the part during sintering. The effect is smaller for smaller parts.

Crucibles made from sheet by deep drawing or by spin forming generally are less brittle and more durable than crucibles made by CIP/sinter or by HIP or by joining (welding). Therefore crucibles made by deep drawing or by spin forming are preferred over crucibles made by other methods.

Monolithic crucibles with a diameter of 380 mm and a height of 430 mm can be made by deep drawing or by spin forming. These processes require a Molybdenum sheet with a width of approximately 950 mm as a starting material. Few manufacturers in the world have access to a rolling mill to make the Molybdenum sheet with the required width. As a result the market prices for this starting material are higher as compared to a starting material with a smaller width. Furthermore the tools and machines required for deep drawing or spin forming are of significant size resulting in the same market situation as described for rolling. For the manufacturing of a non-monolithic crucible cheaper starting material can be used, because for a non-monolithic crucible sheet with a smaller width is required as compared to a monolithic crucible of ordinary design an same size. Furthermore smaller equipment can be used for the deep drawing process or the spin forming process, respectively, which is adding further a cost advantage.

Generally, monolithic crucibles used for the manufacturing of sapphire are use once only. During the sapphire manufacturing process the crucible is damaged beyond repair and has to be scrapped, which is a significant cost. The use of non-monolithic crucibles allows one to reuse the top part of the crucible a number of times. Only the bottom crucible of the crucible has to be scrapped. The reuse of a large part of the crucible allows additional cost savings.

Furthermore the non-monolithic design allows one to use a thinner wall thickness for the top part as compared to the bottom crucible without any additional difficulties in manufacturing the crucible. This freedom in design allows for less material usage, i.e. further cost savings.

While particular embodiments of the present invention have been shown and described, it will be obvious to those skilled in the art that changes and modifications can be made without departing from this invention in its broader aspects. Therefore, the appended claims are to encompass within their scope all such changes and modifications as fall within the true spirit and scope of this invention.

## Claims

1. A non-monolithic crucible, which comprises a bottom part, at least one top part, and one or more optional additional top part,
wherein the bottom part comprises a monolithic bottom crucible is capable of securely containing a liquid of Al₂O₃;
wherein the at least one top part and one or more optional additional top part are mounted onto of the bottom part and on top of each other forming a joint(s) between the parts so as to be able to securely contain a powder of Al₂O₃ without significant powder leakage through any of the parts or through any of the joints between the parts.

2. The non-monolithic crucible according to claim 1, which is made by:
a) CIP - machine on lathe - sinter - machine on lathe,
b) CIP - sinter - machine on lathe,
c) CIP - sinter,
d) HIP - machine on lathe,
e) HIP,
f) assembling the crucible from several parts by joining (welding) - machine on lathe,
g) assembling the crucible from several parts by joining (welding),
h) deep drawing - machine on lathe,
i) deep drawing,
j) spin forming - machine on lathe,
k) spin forming, or
l) a modification of any of the above a)-k) operations.

3. The non-monolithic crucible according to claim 1, which is made from molybdenum and/or tungsten.

4. The non-monolithic crucible according to claim 2, which is made from molybdenum and/or tungsten.

5. The non-monolithic crucible according to any of claims 1-4, wherein the top part is a recycled top part.

6. The non-monolithic crucible according to any of claims 1-5, wherein the joint comprises an anti-sticking material to prevent the joining of top and bottom crucibles by sintering during the use of the non-monolithic crucible.

7. The non-monolithic crucible of claim 6, wherein the anti-sticking material comprises zirconia or tungsten, and wherein the non-monolithic crucible is made from molybdenum.

8. The non-monolithic crucible of claim 6, wherein the anti-sticking material comprises coarse powder particles which do not undergo adverse chemical reactions and have low sinter activity at a high temperature.

9. The non-monolithic crucible according to any of claims 1-8, wherein the contact area between bottom part and the top part(s) is minimized.

10. The non-monolithic crucible according to claim 9, wherein the joint further comprises a position lever to break loose the contact area.

11. A method of fabricating the non-monolithic crucible comprising a bottom part, at least one top part, and one or more optional additional top part, which method comprising:
providing at least one top part and one or more optional additional top part;
providing one bottom part; and
forming the non-monolithic crucible.

12. The method according to claim 11, wherein the non-monolithic crucible is as any of claims 1-10.

13. A method of using a non-monolithic crucible comprising a bottom part, at least one top part, and one or more optional additional top part, which method comprising:
providing a powder of Al₂O₃ to a non-monolithic crucible,
heating the Al₂O₃ at a temperature to generate a liquid of Al₂O₃,
controlling the temperature of the liquid of Al₂O₃ so as to allow a seed of sapphire to grow at a controlled rate into a sapphire product of desired dimension,
removing the top part from the bottom part, and
removing the sapphire product from the bottom part to obtain the sapphire product.

14. The method of claim 13, wherein the non-monolithic crucible is as any of claims 1-10.
